Europäisches Patentamt

European Patent Office

Office européen des brevets

(19)

(11)  EP 1 363 393 A2

(12)  EUROPÄISCHE PATENTANMELDUNG

(43) Veröffentlichungstag:
19.11.2003  Patentblatt 2003/47

(51) Int Cl.⁷: $H03D~7/14$

(21) Anmeldenummer: 03010612.4

(22) Anmeldetag: 12.05.2003

(84) Benannte Vertragsstaaten:
AT BE BG CH CY CZ DE DK EE ES FI FR GB GR
HU IE IT LI LU MC NL PT RO SE SI SK TR
Benannte Erstreckungsstaaten:
AL LT LV MK

(30) Priorität: 15.05.2002  DE 10221620

(71) Anmelder: Infineon Technologies AG
81669 München (DE)

(72) Erfinder: Hackl, Sabine
85640 Putzbrunn (DE)

(74) Vertreter: Viering, Jentschura & Partner
Steinsdorfstrasse 6
80538 München (DE)

(54)  **Mischerschaltung**

(57)     Eine Mischerschaltung weist eine zusätzliche Kapazität auf, die zwischen die Emitter des Eingangs-Transistorpaares geschaltet ist, an welches das RF-Eingangssignal angelegt ist.

# FIG 3

Printed by Jouve, 75001 PARIS (FR)

**Beschreibung**

Die Erfindung betrifft eine Mischerschaltung.

Eine Mischerschaltung wird vor allem in der Hochfrequenztechnik, zum Beispiel in einem HF-Datenübertragungssystem, zur Frequenzumsetzung benötigt.

Um der Nachfrage bei einem solchen Datenübertragungssystem nach immer mehr Bandbreite gerecht zu werden, weicht man in immer höhere Frequenzbänder aus. Eine der Schlüsselkomponenten bei einem solchen Datenübertragungssystem stellt daher eine Mischerschaltung dar, welche im Sender zur Frequenzumsetzung in diese hohen Bänder und im Empfänger zur Rücktransformation bis ins Basisband benötigt werden.

Ein hoher Mischgewinn und ein geringes Rauschen sind in einem solchen Fall wünschenswert, um selbst kleine Eingangssignale in einem ausreichenden Maß verstärken zu können.

Eine bekannte Mischerschaltung kann eine passive Mischerschaltung mit Dioden oder anderen passiven Bauelementen sein. Alternativ kann eine bekannte Mischerschaltung eine aktive Mischerschaltung mit Transistoren sein.

In Anwendungen in Datenübertragungssystemen sind aktive Mischer weitverbreitet. Für die detaillierte Schaltungsform sind hierbei zahlreiche unterschiedliche Ausgestaltungen bekannt.

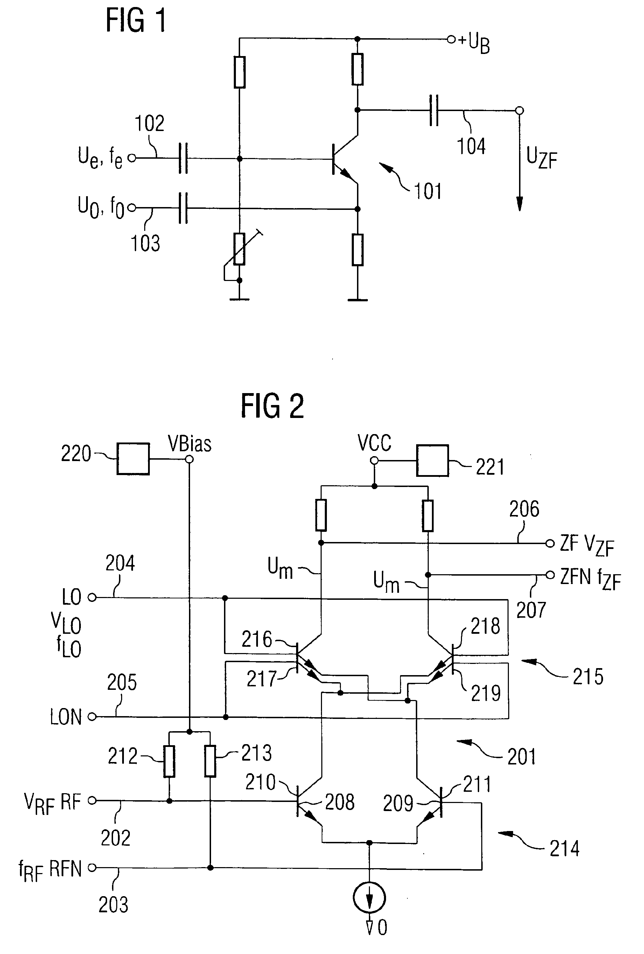

Eine bekannte, sehr einfach aufgebaute aktive Mischerschaltung ist die additive Mischerschaltung, die in **Fig. 1** dargestellt ist. Ein erstes Signal $U_e$ mit einer ersten Frequenz $f_e$ wird über einen ersten Eingang 102 in die Mischerschaltung 101 eingegeben. Ein zweites Signal $U_0$ mit einer zweiten Frequenz $f_0$ wird über einen zweiten Eingang 103 in die Mischerschaltung 101 eingegeben. In der Mischerschaltung 101 werden Mischsignale mit unterschiedlichen Differenzfrequenzen $f_{mij}$, d.h.

$$f_{m11} = |f_e \pm f_0|, \ f_{m21} = |2f_e \pm f_0|, \ f_{m12} = |f_e \pm 2f_0| \text{ etc.} \tag{1}$$

erzeugt.

Die Mischsignale werden am Ausgang 104 der Mischerschaltung 101 ausgegeben.

Eine bekannte, bei Anwendungen, zum Beispiel in der Datenübertragung, weitverbreitete aktive Mischerschaltung ist die nach Barrie Gilbert benannte Gilbertzelle, deren Aufbau in **Fig.2** veranschaulicht ist.

Eine als Gilbertzelle eingerichtete Mischerschaltung 201 weist einen Signaleingang mit einem ersten Signalanschluss RF 202 und einem zweiten Signalanschluss RFN 203, einen Lokaloszillatoreingang mit einem ersten Lokaloszillatoranschluss LO 204 und einem zweiten Lokaloszillatoranschluss LON 205 und einen Zwischenfrequenzausgang mit einem ersten Zwischenfrequenzanschluss ZF 206 und einem zweiten Zwischenfrequenzanschluss ZFN 207 auf.

Die Mischerschaltung 201 weist ferner eine Eingangs-Teilschaltung 214 mit einem ersten Transistor 208 und einem zweiten Transistor 209 und eine Lokaloszillator-Teilschaltung 215 mit einem dritten Transistor 216, einem vierten Transistor 217, einem fünften Transistor 218 und einem sechsten Transistor 219 auf. Der erste Transistor 208 und der zweite Transistor 209 sind an ihren Emitter-Anschlüssen direkt miteinander elektrisch gekoppelt. Der Kollektor-Anschluss des ersten Transistors 208 ist mit dem Emitter-Anschluss des fünften Transistors 218 und mit dem Emitter-Anschluss des vierten Transistors 217 elektrisch gekoppelt. Der Kollektor-Anschluss des zweiten Transistors 209 ist mit dem Emitter-Anschluss des dritten Transistors 216 und mit dem Emitter-Anschluss des sechsten Transistors 219 elektrisch gekoppelt.

Der erste Signalanschluss RF 202 ist mit dem Basis-Anschluss 210 des ersten Transistors 208 elektrisch gekoppelt. Der zweite Signalanschluss RF 203 ist mit dem Basis-Anschluss 211 des zweiten Transistors 209 elektrisch gekoppelt.

Der erste Lokaloszillatoranschluss LO 204 ist mit dem Basis-Anschluss des dritten Transistors 216 und mit dem Basis-Anschluss des fünften Transistors 218 elektrisch gekoppelt. Der zweite Lokaloszillatoranschluss LON 205 ist mit dem Basis-Anschluss des vierten Transistors 217 und mit dem Basis-Anschluss des sechsten Transistors 219 elektrisch gekoppelt.

Der erste Zwischenfrequenzanschluss ZF 206 ist mit dem Kollektor-Anschluss des dritten Transistors 216 und dem Kollektor-Anschluss des vierten Transistors 217 elektrisch gekoppelt. Der zweite Zwischenfrequenzanschluss ZFN 207 ist mit dem Kollektor-Anschluss des fünften Transistors 218 und dem Kollektor-Anschluss des sechsten Transistors 219 elektrisch gekoppelt.

Zum ersten Signalanschluss RF 202 parallelgeschaltet ist ein erster Eingangswiderstand 212, mittels dem zum Einstellen des Arbeitspunkts des ersten Transistors 208 eine Vorspannung $V_{Bias}$ an den Basis-Anschluss des ersten Transistor 208 anlegbar ist. Zum zweiten Signalanschluss RFN 203 parallelgeschaltet ist ein zweiter Eingangswiderstand 213, mittels dem zum Einstellen des Arbeitspunkts des zweiten Transistors 209 die Vorspannung $V_{Bias}$ an den Basis-Anschluss des zweiten Transistor 209 anlegbar ist.

Als Eingangswiderstand 212 kann entweder ein gesonderter Widerstand oder der Innenwiderstand einer Spannungsquelle verwendet werden, die die Vorspannung $V_{Bias}$ bereitstellt. Als Eingangswiderstand 213 kann entweder ein gesonderter Widerstand oder der Innenwiderstand einer ersten Spannungsquelle 220 verwendet werden, die die Vorspannung $V_{Bias}$ bereitstellt.

Über die beiden Signalanschlüsse RF 202 und RFN 203 wird ein hochfrequentes Eingangssignal $V_{RF}$ mit einer Signalfrequenz $f_{RF}$, je nach Polarität des hochfrequenten Eingangssignals, dem Basis-Anschluss 210 des ersten Transistors 208 bzw. dem Basis-Anschluss 211 des zweiten Transistors 209 der Mischerschaltung 201 zugeführt.

Über die beiden Lokaloszillatoranschlüsse LO 204 und LON 205 wird ein Lokaloszillatorsignal $V_{LO}$ mit einer Lokaloszillatorfrequenz $f_{LO}$, je nach Polarität des Lokaloszillatorsignals, dem Basis-Anschluss des dritten Transistors 216 und dem Basis-Anschluss des fünften Transistors 218 bzw. dem Basis-Anschluss des vierten Transistors 217 und dem Basis-Anschluss des sechsten Transistors 219 der Mischerschaltung 201 zugeführt. An den Kollektor-Anschluss des dritten Transistors 216 und an den Kollektor-Anschluss des vierten Transistors 217, bzw. an den Kollektor-Anschluss des fünften Transistors 218 und an den Kollektor-Anschluss des sechsten Transistors 219 wird außerdem über Lastwiderstände eine Versorgungsspannung $V_{CC}$ von einer zweiten Spannungsquelle 221 angelegt.

In der Mischerschaltung 201 wird, wie bei der additiven Mischerschaltung, aus dem hochfrequenten Eingangssignal $V_{RF}$ und dem Lokaloszillatorsignal $V_{LO}$ ein Mischsignal $U_m$ erzeugt, das mittels des Kollektor-Anschlusses des dritten Transistors 216 und mittels des Kollektor-Anschlusses des vierten Transistors 217 am ersten Zwischenfrequenzanschluss ZF 206 des Zwischenfrequenzausgangs ausgebbar ist und mittels des Kollektor-Anschlusses des vierten Transistors 218 und mittels des Kollektor-Anschlusses des sechsten Transistors 219 am zweiten Zwischenfrequenzanschluss ZFN 207 des Zwischenfrequenzausgangs ausgebbar ist.

Das erwünschte Nutzsignal im Mischsignal ist meistens das Zwischenfrequenzsignal $V_{ZF}$ mit der Frequenz

$$f_{ZF} = |f_{RF} - f_{LO}|. \tag{2}$$

Als Gewinn G der Mischerschaltung für das Zwischenfrequenzsignal wird das logarithmische Spannungsverhältnis von Zwischenfrequenzsignal $V_{ZF}$ und Eingangssignal $V_{RF}$ bezeichnet. Der Gewinn G der Mischerschaltung ist frequenzabhängig.

Der Frequenz-Arbeitsbereich ist der Frequenzbereich, in dem die Mischerschaltung einen zu ihrem sinnvollen Betrieb ausreichenden Gewinn G erzielt. Die (obere) 3dB-Grenzfrequenz der Mischerschaltung ist die Frequenz, bei der das logarithmische Spannungsverhältnis zwischen dem Ausgangssignal $U_m$ oder $V_{ZF}$ und dem Eingangssignal $V_{RF}$ -3dB beträgt, und gibt einen Anhaltspunkt für den Frequenz-Arbeitsbereich.

Am Arbeitspunkt der Mischerschaltung hat der Gewinn G bei einer Maximalfrequenz $f_{max}$ innerhalb des Frequenz-Arbeitsbereichs einen Maximalwert $G_{max}$.

Der Frequenz-Arbeitsbereich und der Arbeitspunkt, d.h. die Maximalfrequenz $f_{max}$, sind durch das Schaltungslayout üblicherweise in begrenztem Maß einstellbar.

Es ist wünschenswert, bei einer Mischerschaltung den Gewinn und die Bandbreite zu erhöhen, und möglichst die Rauschzahl, d.h. anders ausgedrückt das Signal-Rausch-Verhältnis nicht zu verschlechtern, möglichst sogar zu verbessern.

Ferner ist in [1] eine Gilbertzelle beschrieben, bei der zwischen die Emitter-Anschlüsse der Bipolartransistoren der Eingangs-Teilschaltung ein ohmscher Widerstand oder eine Induktivität geschaltet ist, wodurch die Linearität der Gilbertzelle verbessert werden soll.

In [2] ist eine Mischerschaltung beschrieben, bei der zwischen einen gesteuerten Anschluss eines ersten Eingangssignal-Transistors und einen gesteuerten Anschluss eines zweiten Eingangssignal-Transistors ein Tiefpassfilter geschaltet ist. Der Tiefpassfilter dient zum Unterdrücken unerwünschter harmonischer Spektralanteile.

Ferner ist in [3] eine weitere Mischerschaltung beschrieben mit einem kapazitiven Element als Ersatz für eine parasitäre Induktivität.

Der Erfindung liegt das Problem zugrunde, eine Mischerschaltung anzugeben, die einen höheren Gewinn und eine größere Bandbreite aufweist.

Das Problem wird gelöst durch eine Mischerschaltungsanordnung mit den Merkmalen gemäß dem unabhängigen Patentanspruch.

Eine Mischerschaltung zum Mischen eines Eingangssignals mit einer Eingangsfrequenz und eines Lokaloszillatorsignals mit einer Lokaloszillatorfrequenz zum Erzeugen eines Zwischenfrequenzsignals mit einer Zwischenfrequenz weist einen Signaleingang auf, an den das Eingangssignal angelegt, d.h. der Mischerschaltung zugeführt werden kann, wobei der Signaleingang einen ersten Signalanschluss und einen zweiten Signalanschluss aufweist. In einer Eingangs-Teilschaltung der Mischerschaltung sind mindestens ein erster Eingangssignal-Transistor und ein zweiter Eingangssignal-Transistor vorgesehen. Jeder Eingangssignal-Transistor weist einen Steueranschluss, anders ausgedrückt einen Steuereingang sowie zwei gesteuerte Anschlüsse auf. Der Steuereingang des ersten Eingangssignal-Transistors ist mit dem ersten Signalanschluss gekoppelt und der Steuereingang des zweiten Eingangssignal-Transistors ist mit dem zweiten Signalanschluss gekoppelt, so dass das differentielle Eingangssignal, d.h. das hochfrequente Eingangssignal $V_{RF}$ mit einer Signalfrequenz $f_{RF}$ den beiden Steuereingängen der Eingangssignal-Transistoren zugeführt werden kann. Die Mischerschaltung weist ferner einen Lokaloszillatoreingang zum Eingeben des Lokaloszillatorsignals in die Mischerschaltung sowie einen Zwischenfrequenzausgang zum Ausgeben des Zwischenfrequenzsignals auf. Zwischen einem ersten gesteuerten Anschluss des ersten Eingangssignal-Transistors und einem ersten gesteuerten Anschluss des zweiten Eingangssignal-Transistors ist eine Kapazität, beispielsweise ein Kondensator, gekoppelt.

Die Kapazität ist somit zwischen die zwei ersten gesteuerten Anschlüsse der Eingangssignal-Transistoren der Eingangs-Teilschaltung der Mischerschaltung geschaltet, wobei die ersten gesteuerten Anschlüsse nicht mit den Transistoren der Lokaloszillator-Teilschaltung der Mischerschaltung gekoppelt sind, d.h. die ersten gesteuerten Anschlüsse sind diejenigen gesteuerten Anschlüsse der Eingangssignal-Transistoren, die auf der von der Lokaloszillator-Teilschaltung abgewandten Seite der Mischerschaltung angeordnet sind, vorzugsweise aus Sicht der Eingangs-Teilschaltung erdungsseitig. Die zweiten gesteuerten Anschlüsse der Eingangssignal-Transistoren sind mit den Transistoren der Lokaloszillator-Teilschaltung gekoppelt zum Mischen des Eingangssignals mit dem Lokaloszillatorsignal.

Die erfindungsgemäße Mischerschaltung weist eine gegenüber der in [1] beschriebenen Mischerschaltung erheblich erhöhte 3 dB-Bandbreite auf sowie einen höheren Mischgewinn. Auch die Rauschzahl der erfindungsgemäßen Mischerschaltung ist gegenüber der bekannten Mischerschaltung erheblich reduziert.

Die erfindungsgemäße Mischerschaltungsanordnung hat zudem den Vorteil, dass sie einfach, zuverlässig und leistungsfähig ist.

Es hat sich bei einer erfindungsgemäßen Mischerschaltung herausgestellt, dass im Vergleich zu einer strukturgleichen Mischerschaltung ohne die Kapazität die maximale 3 dB-Bandbreite von 14-38 GHz auf 12-42 GHz erhöht ist, mit einer gleichzeitigen maximalen Erhöhung des Mischgewinns von 17 dB auf 26 dB. Bezüglich der maximalen 3 dB-Bandbreite wurde somit in diesem Fall eine Verbesserung um 6 GHz und bezüglich des Mischgewinns um 9 dB erreicht. Die minimale Rauschzahl wurde in dem gemessenen Fall von 16,3 dB um 3,3 dB auf 13 dB verbessert.

Anschaulich kann die Erfindung darin gesehen werden, dass die zusätzliche Kapazität zwischen den ersten gesteuerten Anschlüssen der Transistoren der Eingangs-Teilschaltung gemeinsam mit induktiv wirkenden Bauelementen der Mischerschaltung eine Resonanz gebildet wird, wodurch der Mischgewinn und die Bandbreite erhöht werden und die Rauschzahl reduziert wird.

Bevorzugte Weiterbildungen der Erfindung ergeben sich aus den abhängigen Ansprüchen.

Gemäß einer Ausgestaltung der Erfindung ist die Mischerschaltung volldifferentiell eingerichtet. Vorzugsweise weist der Lokaloszillatoreingang der Mischerschaltung somit einen ersten Lokaloszillatoranschluss und einen zweiten Lokaloszillatoranschluss auf. Der Zwischenfrequenzausgang weist gemäß dieser Ausgestaltung der Erfindung einen ersten Zwischenfrequenzanschluss und einen zweiten Zwischenfrequenzanschluss auf.

Eine sehr kostengünstige und einfach herstellbare Mischerschaltung ergibt sich bei einer Ausgestaltung der Mischerschaltung als eine Gilbertzelle.

Gemäß einer Weiterbildung der Erfindung ist zumindest ein Teil der Transistoren als Bipolartransistoren ausgestaltet, in welchem Fall vorzugsweise der erste Eingangssignal-Transistor und der zweite Eingangssignal-Transistor Bipolartransistoren sind. Der Steuereingang des ersten Eingangssignal-Transistors ist in diesem Fall der Basis-Anschluss des ersten Eingangssignal-Transistors und der Steuereingang des zweiten Eingangssignal-Transistors ist der Basis-Anschluss des zweiten Eingangssignal-Transistors. Der erste gesteuerte Anschluss des ersten Eingangssignal-Transistors ist in diesem Fall der Emitter-Anschluss des ersten Eingangssignal-Transistors und der erste gesteuerte Anschluss des zweiten Eingangssignal-Transistors ist in diesem Fall der Emitter-Anschluss des zweiten Eingangssignal-Transistors. Die Transistoren können als pnp-Bipolartransisoren oder alternativ als npn-Bipolartransisoren ausgestaltet sein.

Anders ausgedrückt bedeutet dies, dass gemäß dieser Ausgestaltung der Erfindung die Kapazität zwischen die Emitter der beiden Bipolartransistoren der Eingangs-Teilschaltung der Mischerschaltung, d.h. zwischen die Emitter des Transistorpaares, an deren Basis-Anschlüsse das RF-Eingangssignal angelegt ist, geschaltet ist.

Alternativ kann zumindest ein Teil der Transistoren als MOS-Feldeffekttransistoren (**M**etal-**O**xide-**S**emiconductor-Feldeffekttransistoren) eingerichtet sein. In diesem Fall können die MOS-Feldeffekttransistoren als n-Kanal-MOS-Feldeffekttransistoren oder als p-Kanal-MOS-Feldeffekttransistoren ausgestaltet sein.

In diesem sind vorzugsweise der erste Eingangssignal-Transistor und der zweite Eingangssignal-Transistor als MOS-Feldeffekttransistoren eingerichtet und der Steuereingang des ersten Eingangssignal-Transistors ist der Gate-Anschluss des ersten Eingangssignal-Transistors. Der Steuereingang des zweiten Eingangssignal-Transistors ist der Gate-Anschluss des zweiten Eingangssignal-Transistors. Der erste gesteuerte Anschluss des ersten Eingangssignal-Transistors ist in diesem Fall ein erster Source-/Drain-Anschluss, vorzugsweise der Source-Anschluss, des ersten Eingangssignal-Transistors und der erste gesteuerte Anschluss des zweiten Eingangssignal-Transistors ist in diesem Fall ein erster Source-/Drain-Anschluss, vorzugsweise der Source-Anschluss, des zweiten Eingangssignal-Transistors.

Die Mischerschaltung ist gemäß einer Weiterbildung der Erfindung zumindest teilweise als monolithisch integrierte Schaltung ausgebildet, vorzugsweise basierend auf Silizium.

Dies ermöglicht eine sehr einfache und kostengünstige Realisierung der Mischerschaltung.

Alternativ sind die Mischerschaltung mit ihren Transistoren und ggf. sonstigen Bauelementen als gehäuste oder ungehäuste Einzelbauteile vorgesehen, die zum Beispiel auf einer Platine miteinander entsprechend der gewünschten Funktionalität miteinander verlötet sind.

Als der monolithisch hochintegrierten Schaltung zugrundeliegende Technologie(n) sind grundsätzlich beliebige Technologien möglich. Die Mischerschaltungsanordnung kann zum Beispiel zumindest teilweise auf Silizium basieren, oder sie kann zumindest teilweise auf einem Verbindungshalbleiter, zum Beispiel mit einem III-V-Halbleiter wie GaAs, InP, InSb oder einem oder mehreren anderen bekannten III-V-Halbleitern, oder auf einem II-VI-Halbleiter, oder auf SiGe basieren. BiCMOS, CMOS oder sonstige bekannte Technologien sind mögliche Technologien zur Verwirklichung der Schaltungsanordnung.

Eine sehr schnelle Mischerschaltung ergibt sich für den Fall, dass sie zumindest teilweise auf SiGe-Technologie basierend realisiert ist.

Ausführungsbeispiele der Erfindung sind in den Figuren dargestellt und werden im Weiteren näher erläutert.

Es zeigen

Figur 1     ein Schaltungsdiagramm einer additiven Mischerschaltung gemäß dem Stand der Technik;

Figur 2     ein Schaltungsdiagramm einer Gilbertzelle gemäß dem Stand der Technik;

Figur 3     ein Schaltungsdiagramm einer Mischerschaltung gemäß einem ersten Ausführungsbeispiel der Erfindung;

Figur 4     ein Schaltungsdiagramm einer Mischerschaltung gemäß einem zweiten Ausführungsbeispiel der Erfindung;

Figur 5     eine Skizze, in der der ermittelte Mischgewinn abhängig von der Signalfrequenz des Eingangssignals bei einer gemäß Figur 3 ausgestalteten Mischerschaltung und der Mischgewinn bei einer ansonsten strukturgleichen Mischerschaltung ohne die zusätzliche Kapazität zwischen den Emittern der Transistoren der Eingangs-Teilschaltung, dargestellt sind; und

Figur 6     eine Skizze, in der die ermittelte Zweiseitenband-Rauschzahl abhängig von der Signalfrequenz des Eingangssignals bei einer gemäß Figur 3 ausgestalteten Mischerschaltung und die Zweiseitenband-Rauschzahl bei einer ansonsten strukturgleichen Mischerschaltung ohne die zusätzliche Kapazität zwischen den Emittern der Transistoren der Eingangs-Teilschaltung, dargestellt sind.

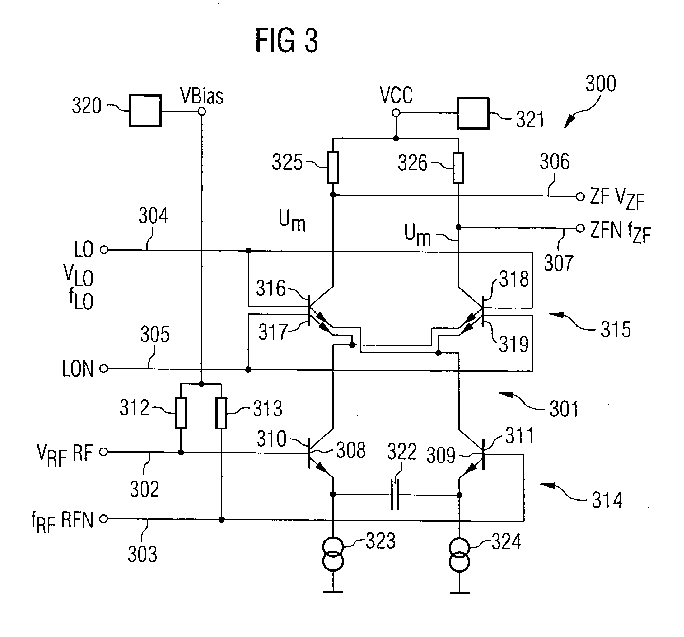

**Fig.3** zeigt eine Skizze einer Mischerschaltungsanordnung 300 gemäß einem ersten Ausführungsbeispiel der Erfindung.

In der Mischerschaltungsanordnung ist eine als Gilbertzelle eingerichtete Mischerschaltung vorgesehen.

Bei einem Transistor in einer Figur der Zeichnung ist im allgemeinen der Emitteranschluss durch einen Pfeil gekennzeichnet.

Die Mischerschaltungsanordnung 300 weist eine Gilbertzelle als Mischerschaltung 301 auf sowie einen Signaleingang mit einem ersten Signalanschluss RF 302 und einem zweiten Signalanschluss RFN 303, einen Lokaloszillatoreingang mit einem ersten Lokaloszillatoranschluss LO 304 und einem zweiten Lokaloszillatoranschluss LON 305 und einen Zwischenfrequenzausgang mit einem ersten Zwischenfrequenzanschluss ZF 306 und einem zweiten Zwischenfrequenzanschluss ZFN 307 auf.

Die Mischerschaltung 301 weist eine Eingangs-Teilschaltung 314 mit einem ersten Transistor 308 und einem zweiten Transistor 309 und eine Lokaloszillator-Teilschaltung 315 mit einem dritten Transistor 316, einem vierten Transistor 317, einem fünften Transistor 318 und einem sechsten Transistor 319 auf.

Der Emitter-Anschluss des ersten Transistors 308 ist mit einem ersten Anschluss einer Kapazität 322 gekoppelt, deren zweiter Anschluss mit dem Emitter-Anschluss des zweiten Transistors 309 gekoppelt ist.

Ferner ist der erste Anschluss der Kapazität 322 mit einem ersten Anschluss einer ersten Stromquelle 323 gekoppelt, deren zweiter Anschluss an das Massepotential angeschlossen ist. Der zweite Anschluss der Kapazität 322 ist mit einem ersten Anschluss einer zweiten Stromquelle 324 gekoppelt, deren zweiter Anschluss ebenfalls an das Massepotential angeschlossen ist. Die Kapazität 322 hat gemäß diesem Ausführungsbeispiel einen Wert von 1 pF.

Der Kollektor-Anschluss des ersten Transistors 308 ist mit dem Emitter-Anschluss des fünften Transistors 318 und mit dem Emitter-Anschluss des vierten Transistors 317 elektrisch gekoppelt. Der Kollektor-Anschluss des zweiten Transistors 309 ist mit dem Emitter-Anschluss des dritten Transistors 316 und mit dem Emitter-Anschluss des sechsten Transistors 319 elektrisch gekoppelt.

Der erste Signalanschluss RF 302 ist mit dem Basis-Anschluss 310 des ersten Transistors 308 elektrisch gekoppelt. Der zweite Signalanschluss RF 303 ist mit dem Basis-Anschluss 311 des zweiten Transistors 309 elektrisch gekoppelt.

Der erste Lokaloszillatoranschluss LO 304 ist mit dem Basis-Anschluss des dritten Transistors 316 und mit dem Basis-Anschluss des fünften Transistors 318 elektrisch gekoppelt. Der zweite Lokaloszillatoranschluss LON 305 ist mit dem Basis-Anschluss des vierten Transistors 317 und mit dem Basis-Anschluss des sechsten Transistors 319 elektrisch gekoppelt.

Der erste Zwischenfrequenzanschluss ZF 306 ist mit dem Kollektor-Anschluss des dritten Transistors 316 und dem Kollektor-Anschluss des vierten Transistors 317 elektrisch gekoppelt. Der zweite Zwischenfrequenzanschluss ZFN 307 ist mit dem Kollektor-Anschluss des fünften Transistors 318 und dem Kollektor-Anschluss des sechsten Transistors 319 elektrisch gekoppelt.

Zum ersten Signalanschluss RF 302 parallelgeschaltet ist ein erster Eingangswiderstand 312, mittels dem zum Einstellen des Arbeitspunkts des ersten Transistors 308 eine Vorspannung $V_{Bias}$ an den Basis-Anschluss des ersten Transistor 308 anlegbar ist. Zum zweiten Signalanschluss RFN 303 parallelgeschaltet ist ein zweiter Eingangswiderstand 313, mittels dem zum Einstellen des Arbeitspunkts des zweiten Transistors 309 die Vorspannung $V_{Bias}$ an den Basis-Anschluss des zweiten Transistor 309 anlegbar ist.

Als Eingangswiderstand 312 kann entweder ein gesonderter Widerstand oder der Innenwiderstand einer ersten Spannungsquelle 320 verwendet werden, die die Vorspannung $V_{Bias}$ bereitstellt. Als Eingangswiderstand 313 kann ebenfalls entweder ein gesonderter Widerstand oder der Innenwiderstand der ersten Spannungsquelle 320 verwendet werden, die die Vorspannung $V_{Bias}$ bereitstellt.

Der Widerstandswert der beiden Eingangswiderstände 312 und 313 beträgt je 50 Ohm. Bei einer alternativen Ausführungsform der erfindungsgemäßen Mischerschaltungsanordnung beträgt der Widerstandswert der beiden Eingangswiderstände 312 und 313 je 200 Ohm, bei einer weiteren Ausführungsform je 300 Ohm.

Über die beiden Signalanschlüsse RF 302 und RFN 303 wird ein hochfrequentes Eingangssignal $V_{RF}$ mit einer Signalfrequenz $f_{RF}$, je nach Polarität des hochfrequenten Eingangssignals, dem Basis-Anschluss 310 des ersten Transistors 308 bzw. dem Basis-Anschluss 311 des zweiten Transistors 309 der Mischerschaltung 301 zugeführt.

Über die beiden Lokaloszillatoranschlüsse LO 304 und LON 305 wird ein Lokaloszillatorsignal $V_{LO}$ mit einer Lokaloszillatorfrequenz $f_{LO}$, je nach Polarität des Lokaloszillatorsignals, dem Basis-Anschluss des dritten Transistors 316 und dem Basis-Anschluss des fünften Transistors 318 bzw. dem Basis-Anschluss des vierten Transistors 317 und dem Basis-Anschluss des sechsten Transistors 319 der Mischerschaltung 301 zugeführt. An den Kollektor-Anschluss des dritten Transistors 316 und an den Kollektor-Anschluss des vierten Transistors 317, bzw. an den Kollektor-Anschluss des fünften Transistors 318 und an den Kollektor-Anschluss des sechsten Transistors 319 wird außerdem über Lastwiderstände 325, 326 eine Versorgungsspannung $V_{CC}$ von einer zweiten Spannungsquelle 321 angelegt.

In der Mischerschaltung 301 wird, wie bei der additiven Mischerschaltung, aus dem hochfrequenten Eingangssignal $V_{RF}$ und dem Lokaloszillatorsignal $V_{LO}$ ein Mischsignal $U_m$ erzeugt, das mittels des Kollektor-Anschlusses des dritten Transistors 316 und mittels des Kollektor-Anschlusses des vierten Transistors 317 am ersten Zwischenfrequenzanschluss ZF 306 des Zwischenfrequenzausgangs ausgebbar ist und mittels des Kollektor-Anschlusses des vierten Transistors 318 und mittels des Kollektor-Anschlusses des sechsten Transistors 319 am zweiten Zwischenfrequenzanschluss ZFN 307 des Zwischenfrequenzausgangs ausgebbar ist.

Das erwünschte Nutzsignal im Mischsignal ist meistens das Zwischenfrequenzsignal $V_{ZF}$ mit der Frequenz

$$f_{ZF} = |f_{RF} - f_{LO}|. \qquad (2)$$

Gemäß dem ersten Ausführungsbeispiel sind die Transistoren als Silizium-Germanium-Bipolartransistoren eingerichtet. Die Mischerschaltung gemäß dieser Ausführungsform zeichnet sich durch eine besonders hohe Betriebsfrequenz aus.

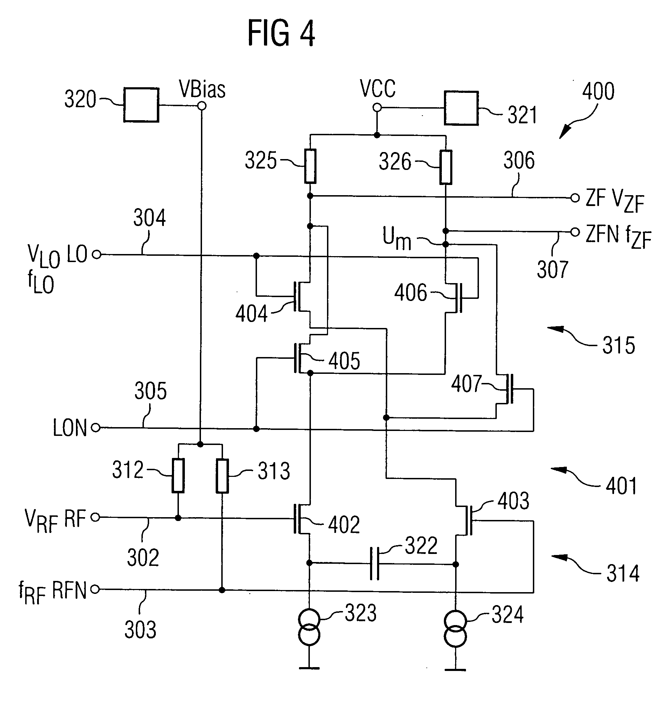

**Fig.4** zeigt eine Skizze einer Mischerschaltungsanordnung 400 gemäß einem zweiten Ausführungsbeispiel der Erfindung.

Die Mischerschaltungsanordnung 400 gemäß dem zweiten Ausführungsbeispiel der Erfindung entspricht im Wesentlichen der Mischerschaltungsanordnung 300 gemäß dem ersten Ausführungsbeispiel der Erfindung, weshalb gleiche Elemente in den Figuren mit gleichen Bezugszeichen versehen sind.

Die Mischerschaltungsanordnung 400 gemäß dem zweiten Ausführungsbeispiel der Erfindung unterscheidet sich von der Mischerschaltungsanordnung 300 gemäß dem ersten Ausführungsbeispiel der Erfindung im Wesentlichen darin, dass die Transistoren der Mischerschaltung 401, d.h. der erste Transistor 402, der zweite Transistor 403, der dritte Transistor 404, der vierte Transistor 405, der fünfte Transistor 406 sowie der sechste Transistor 407 als MOS-Feldeffekttransistoren ausgebildet sind.

Gemäß diesem Ausführungsbeispiel ist die Kapazität 322 zwischen die Source-Anschlüsse des ersten Transistors 402 und des zweiten Transistors 403 gekoppelt.

Die erfindungsgemäße Mischerschaltung eignet sich insbesondere für den Einsatz in der Signalverarbeitung bei hohen Trägerfrequenzen, beispielsweise bei Punkt-zu-Multipunkt-Kommunikationsverbindungen 10,5 GHZ, bei 24 GHz oder bei 26 GHz oder bei LMDS (**L**ocal **M**ultipoint **D**istribution **S**ystem) bei 28 GHz und 38 GHz und MVDS (**M**ultipoint **V**ideo **D**istribution **S**ystems) bei 42 GHz.

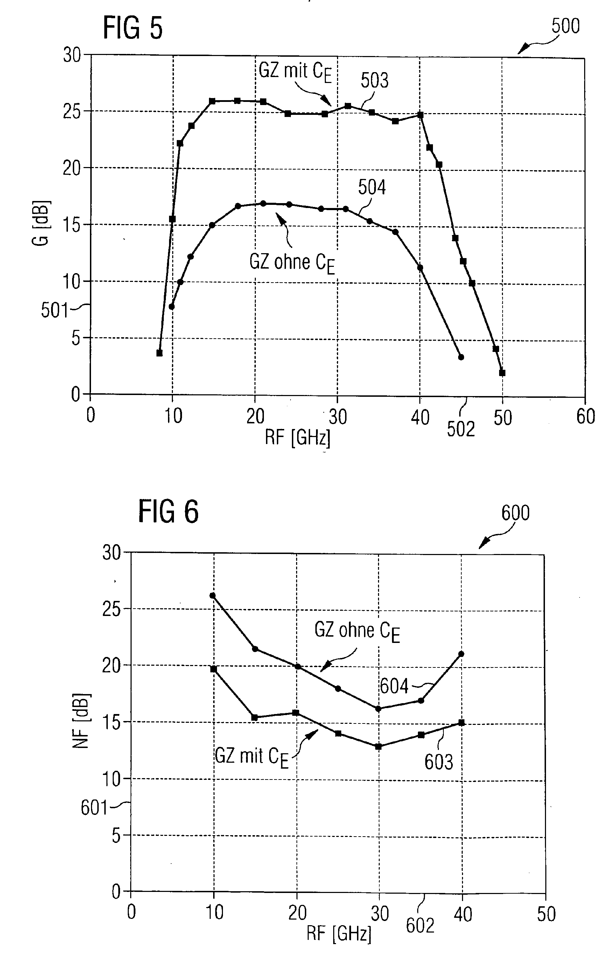

**Fig.5** zeigt ein Diagramm 500, in der der gemessene Mischgewinn G 501 abhängig von der Signalfrequenz RF 502 des RF-Eingangssignals bei einer gemäß Fig.3 ausgestalteten Mischerschaltung 301 (als eine erste Mischgewinnkurve 503) und der Mischgewinn G 501 bei einer Mischerschaltung ohne die zusätzliche Kapazität zwischen den Emittern der Transistoren der Eingangs-Teilschaltung, mit ansonsten gleicher Struktur (als eine zweite Mischgewinnkurve 504), dargestellt sind.

Wie Fig.5 zu entnehmen ist hat sich herausgestellt, dass im Vergleich zu einer strukturgleichen Mischerschaltung ohne die Kapazität die maximale 3 dB-Bandbreite von 14-38 GHz erfindungsgemäß auf 12-42 GHz erhöht ist, mit einer gleichzeitigen maximalen Erhöhung des Mischgewinns von 17 dB auf 26 dB. Bezüglich der maximalen 3 dB-Bandbreite wurde somit in diesem Fall eine Verbesserung um 6 GHz und bezüglich des Mischgewinns um 9 dB erreicht.

**Fig.6** zeigt ein Diagramm 600, in der die gemessene Zweiseitenband-Rauschzahl NF 601 abhängig von der Signalfrequenz RF 602 des RF-Eingangssignals bei einer gemäß Fig.3 ausgestalteten Mischerschaltung 301 (als eine erste Rauschzahlkurve 603) und die Zweiseitenband-Rauschzahl NF 601 bei einer Mischerschaltung ohne die zusätzliche Kapazität zwischen den Emittern der Transistoren der Eingangs-Teilschaltung, mit ansonsten gleicher Struktur (als eine zweite Mischgewinnkurve 604), dargestellt sind.

Wie Fig.6 zu entnehmen ist hat sich herausgestellt, dass im Vergleich zu einer strukturgleichen Mischerschaltung ohne die Kapazität die minimale Rauschzahl in dem gemessenen Fall von 16,3 dB um 3,3 dB auf 13 dB verbessert worden ist.

Anschaulich kann die Erfindung darin gesehen werden, dass zwischen den Emittern des Transistorpaares am RF-Signaleingang eines Mischers, vorzugsweise eines Gilbertmischers, eine zusätzliche Kapazität geschaltet ist, mittels der gemeinsam mit induktiv wirkenden Bauelementen in dem Mischer eine Resonanz gebildet wird, wodurch der Mischgewinn und die 3 dB-Bandbreite erhöht wird und die Rauschzahl reduziert wird.

In diesem Dokument ist folgende Veröffentlichung zitiert:

[1] B. Gilbert, Mixer Fundamentals and Active Mixer Design, Electronics Laboratories Advanced Engineering Course on RF IC Design for Wireless Communication Systems, Lausanne, Schweiz, S. 57 - 61, 3.-7. Juli 1995

[2] DE 197 08 007 A1

[3] US 5,379,457

**Bezugszeichenliste**

101     Mischerschaltung
102     Erster Eingang
103     Zweiter Eingang
104     Ausgang
105     Mischer-Transistor
106     Basis
107     Emitter
108     Kollektor

201     Mischerschaltung
202     Erster Signalanschluss RF
203     Zweiter Signalanschluss RFN
204     Erster Lokaloszillatoranschluss LO
205     Zweiter Lokaloszillatoranschluss LON
206     Erster Zwischenfrequenzanschluss ZF

207     Zweiter Zwischenfrequenzanschluss ZFN
208     Erster Transistor
209     Zweiter Transistor
210     Basis des ersten Transistors
211     Basis des zweiten Transistors
212     Erster Eingangswiderstand
213     Zweiter Eingangswiderstand
214     Eingangsteilschaltung
215     Lokaloszillatorteilschaltung
216     Dritter Transistor
217     Vierter Transistor
218     Fünfter Transistor
219     Sechster Transistor
220     Erste Spannungsquelle
221     Zweite Spannungsquelle

300     Mischerschaltungsanordnung
301     Mischerschaltung
302     Erster Signalanschluss RF
303     Zweiter Signalanschluss RFN
304     Erster Lokaloszillatoranschluss LO
305     Zweiter Lokaloszillatoranschluss LON
306     Erster Zwischenfrequenzanschluss ZF
307     Zweiter Zwischenfrequenzanschluss ZFN
308     Erster Transistor
309     Zweiter Transistor
310     Basis-Anschluss des ersten Transistors
311     Basis-Anschluss des zweiten Transistors
312     Erster Eingangswiderstand
313     Zweiter Eingangswiderstand
314     Eingangs-Teilschaltung
315     Lokaloszillatorteilschaltung
316     Dritter Transistor
317     Vierter Transistor
318     Fünfter Transistor
319     Sechster Transistor
320     Erste Spannungsquelle
321     Zweite Spannungsquelle
323     Erste Stromquelle
324     Zweite Stromquelle
325     Lastwiderstand
326     Lastwiderstand

400     Mischerschaltungsanordnung
401     Mischerschaltung
402     Erster Transistor
403     Zweiter Transistor
404     Dritter Transistor
405     Vierter Transistor
406     Fünfter Transistor
407     Sechster Transistor

500     Diagramm
501     Mischgewinn
502     Frequenz
503     Erste Mischgewinnkurve
504     Zweite Mischgewinnkurve

600 Diagramm
601 Zweiseitenband-Rauschzahl
602 Frequenz
603 Erste Rauschzahlkurve
604 Zweite Rauschzahlkurve


**Patentansprüche**

1. Mischerschaltung (201) zum Mischen eines Eingangssignals (VRF) mit einer Eingangsfrequenz (fRF) und eines Lokaloszillatorsignals (VLO) mit einer Lokaloszillatorfrequenz (fLO) zum Erzeugen eines Zwischenfrequenzsignals (ZF) mit einer Zwischenfrequenz (fZF),

   - mit einem Signaleingang zum Eingeben des Eingangssignals (VRF), wobei der Signaleingang einen ersten Signalanschluss und einen zweiten Signalanschluss (RF 202, RFN 203) aufweist,
   - mit einem ersten Eingangssignal-Transistor, dessen Steuereingang mit dem ersten Signalanschluss gekoppelt ist,
   - mit einem zweiten Eingangssignal-Transistor, dessen Steuereingang mit dem zweiten Signalanschluss gekoppelt ist,
   - mit einem Lokaloszillatoreingang zum Eingeben des Lokaloszillatorsignals (VLO) in die Mischerschaltung (201), und
   - mit einem Zwischenfrequenzausgang zum Ausgeben des Zwischenfrequenzsignals (VZF),
   - mit einer Kapazität zwischen einem ersten gesteuerten Anschluss des ersten Eingangssignal-Transistors und einem ersten gesteuerten Anschluss des zweiten Eingangssignal-Transistors.

2. Mischerschaltung (201) nach Anspruch 1, bei der

   - der Lokaloszillatoreingang einen ersten und einen zweiten Lokaloszillatoranschluss (LO 204, LON 205) aufweist, und
   - der Zwischenfrequenzausgang einen ersten und einen zweiten Zwischenfrequenzanschluss (ZF 206, ZFN 207) aufweist.

3. Mischerschaltung (201) nach Anspruch 1 oder 2, eingerichtet als eine Gilbertzelle.

4. Mischerschaltung (201) nach einem der Ansprüche 1 bis 3, bei der zumindest ein Teil der Transistoren Bipolartransistoren sind.

5. Mischerschaltung (201) nach Anspruch 4,

   - bei der der erste Eingangssignal-Transistor und der zweite Eingangssignal-Transistor Bipolartransistoren sind,
   - bei der der Steuereingang des ersten Eingangssignal-Transistors und des zweites Eingangssignal-Transistors jeweils deren Basis-Anschluss ist, und
   - bei der der erste gesteuerten Anschluss des ersten Eingangssignal-Transistors und des zweiten Eingangssignal-Transistors jeweils deren Emitter-Anschluss ist.

6. Mischerschaltung (201) nach einem der Ansprüche 1 bis 3, bei der zumindest ein Teil der Transistoren MOS-Feldeffekttransistoren sind.

7. Mischerschaltung (201) nach Anspruch 6,

   - bei der der erste Eingangssignal-Transistor und der zweite Eingangssignal-Transistor MOS-Feldeffekttransistoren sind,
   - bei der der Steuereingang des ersten Eingangssignal-Transistors und des zweites Eingangssignal-Transistors jeweils deren Gate-Anschluss ist, und
   - bei der der erste gesteuerten Anschluss des ersten Eingangssignal-Transistors und des zweiten Eingangssignal-Transistors jeweils deren Source-Anschluss ist.

8. Mischerschaltung (201) nach einem der Ansprüche 1 bis 7, die zumindest teilweise als monolithisch integrierte Schaltung ausgebildet ist.

9. Mischerschaltung (201) nach Anspruch 8, die zumindest teilweise auf Silizium basiert.

10. Mischerschaltung (201) nach Anspruch 8, die zumindest teilweise auf zumindest einem Verbindungshalbleiter basiert.

11. Mischerschaltung (201) nach Anspruch 9 oder 10, die zumindest teilweise auf BiCMOS-Technologie basiert.

12. Mischerschaltung (201) nach Anspruch 9 oder 10, die zumindest teilweise auf CMOS-Technologie basiert.

13. Mischerschaltung (201) nach Anspruch 9 oder 10, die zumindest teilweise auf SiGe-Technologie basiert.

# FIG 1

# FIG 2

# FIG 3

# FIG 4

FIG 5

FIG 6